(19) **Europäisches Patentamt**
**European Patent Office**
**Office européen des brevets**

(11) **EP 1 606 882 B1**

(12) **EUROPÄISCHE PATENTSCHRIFT**

(45) Veröffentlichungstag und Bekanntmachung des Hinweises auf die Patenterteilung:
**04.03.2009 Patentblatt 2009/10**

(21) Anmeldenummer: **04723566.8**

(22) Anmeldetag: **26.03.2004**

(51) Int Cl.:
**H03L 7/093** (2006.01)

(86) Internationale Anmeldenummer:
**PCT/EP2004/003261**

(87) Internationale Veröffentlichungsnummer:
**WO 2004/086626 (07.10.2004 Gazette 2004/41)**

(54) **FREQUENZGENERATOR MIT EINER PHASENREGELSCHLEIFE**

FREQUENCY GENERATOR PROVIDED WITH A PHASE-LOCKED LOOP

GENERATEUR DE FREQUENCE A BOUCLE A PHASE ASSERVIE

(84) Benannte Vertragsstaaten:
**AT BE BG CH CY CZ DE DK EE ES FI FR GB GR HU IE IT LI LU MC NL PL PT RO SE SI SK TR**

(30) Priorität: **27.03.2003 DE 10313884**

(43) Veröffentlichungstag der Anmeldung:
**21.12.2005 Patentblatt 2005/51**

(73) Patentinhaber: **Fraunhofer-Gesellschaft zur Förderung der angewandten Forschung e.V. 80686 München (DE)**

(72) Erfinder:
• **CHRISTOFFERS, Niels
47058 Duisburg (DE)**
• **KOKOZINSKI, Rainer
46147 Oberhausen (DE)**
• **HOSTICKA, Bedrich
45478 Mühlheim (DE)**

• **KOLNSBERG, Stephan
47803 Krefeld (DE)**

(74) Vertreter: **Schoppe, Fritz et al
Schoppe, Zimmermann, Stöckeler & Zinkler
Patentanwälte
Postfach 246
82043 Pullach bei München (DE)**

(56) Entgegenhaltungen:
**US-A- 3 740 671        US-A- 5 977 838
US-A- 6 008 703**

• **"MAX260/MAX261/MAX262 Microprocessor Programmable Universal Active Filter" Datasheet 19-0352 Rev 2, MAXIM Integrated Products, Sunnyvale, USA, Juli 2002 (2002-07-00) Seite 1, Absatz Application, Seite 18 XP002293213**

EP 1 606 882 B1

**Beschreibung**

Die vorliegende Erfindung bezieht sich auf einen Frequenzgenerator mit einer Phasenregelschleife bzw. einer phasengekoppelten Regelschleife mit einem Schleifenfilter.

Frequenzgeneratoren mit einer Phasenregelschleife (PLL; PLL = phase locked loop) werden in vielen Bereichen eingesetzt, beispielsweise bei einem digitalen drahtlosen Kommunikationssystem wie Bluetooth. In einem solchen Kommunikationssystem erzeugt ein Frequenzgenerator das Trägersignal, das zur Modulation im Sender bzw. beim Senden und zur Demodulation im Empfänger bzw. beim Empfangen verwendet wird. Jedem Kommunikationssystem ist ein Frequenzband zugeordnet. Das Kommunikationssystem kann alle Frequenzen innerhalb dieses Frequenzbandes nutzen, um Daten bzw. Informationen vom Sender zum Empfänger zu übertragen. Die Leistung von Signalen, die der Sender außerhalb des zugeordneten Frequenzbandes erzeugt, dürfen eine bestimmte Grenze nicht überschreiten, um Kommunikationssysteme, die benachbarte Frequenzbänder nutzen, nicht zu stören. Die Signalanteile außerhalb des zugeordneten Frequenzbandes sind dabei um so größer, je größer das Phasenrauschen $S_\phi$ ist, mit dem der Träger bzw. die Trägerfrequenz behaftet ist. Deshalb muß das Phasenrauschen $S_\phi$ bei einer bestimmten Frequenzablage $\Delta f_{sp}$ vom Träger unterhalb einer vorbestimmten Grenze $S_{\phi max}$ liegen.

Eine weitere Anforderung an einen Frequenzgenerator ist, daß er nach Bekanntgabe einer auszugebenden bzw. erwünschten Ausgangsfrequenz bzw. Soll-Frequenz innerhalb einer möglichst kurzen Einschwingzeit die Ausgabefrequenz hinreichend genau auf die Soll-Ausgabefrequenz einstellt. Dazu kommen weitere Anforderungen, die unter anderem vom verwendeten Modulationsverfahren abhängen. Beispielsweise ist bei einem FSK-Verfahren (FSK = frequency shift keying = Frequenzumtastung) eine direkte Modulierbarkeit der Ausgangsfrequenz des Frequenzgenerators vorteilhaft und erwünscht.

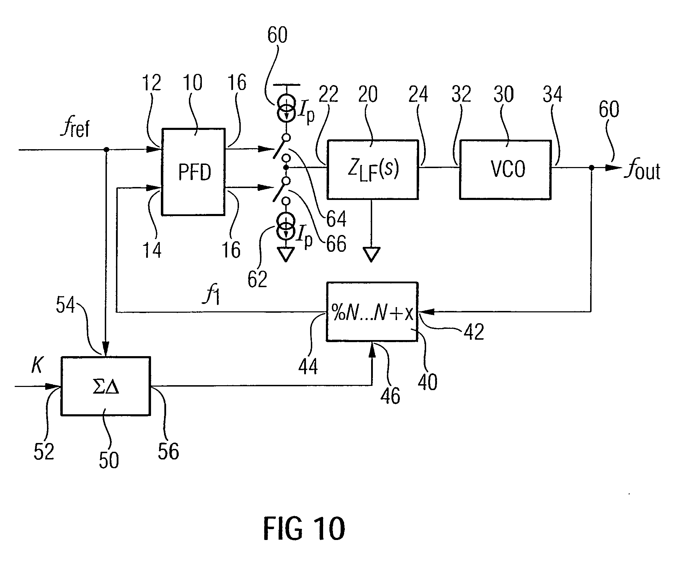

Fig. 10 ist ein schematisches Schaltungsdiagramm, das ein Beispiel für einen auf einer Phasenregelschleife basierenden Frequenzgenerator zeigt. Ein Phasen/Frequenz-Detektor PFD 10 umfaßt einen Referenzsignaleingang 12 zum Empfangen eines Referenzsignals mit einer Referenzfrequenz $f_{ref}$, einen Vergleichssignaleingang zum Empfangen eines Vergleichssignals mit einer Vergleichsfrequenz $f_1$ und einen Steuerausgang 16 zum Ausgeben eines Oszillatorsteuersignals. Der Phasen/Frequenz-Detektor 10 bildet das Oszillatorsteuersignal abhängig von der Differenz zwischen der Vergleichsfrequenz $f_1$ des am Vergleichssignaleingang 14 anliegenden Vergleichssignals und der Referenzfrequenz $f_{ref}$ des am Referenzsignaleingang 12 anliegenden Referenzsignals.

Ein Schleifenfilter 20 umfaßt einen Eingang 22, der mit dem Steuerausgang 16 des Phasen/Frequenz-Detektors 10 verbunden ist, und einen Ausgang 24. Das Schleifenfilter 20 ist in der Regel ein Tiefpaßfilter, meist ein RC-Filter. Es filtert das am Eingang 22 von dem Phasen/Frequenz-Detektor 10 empfangene Oszillatorsteuersignal, um ein gefiltertes Oszillatorsteuersignal zu erzeugen, das es am Ausgang 24 ausgibt. Ein Oszillator 30 umfaßt einen Eingang 32, der mit dem Ausgang 24 des Schleifenfilters 20 verbunden ist, und einen Ausgang 34. Der Oszillator 30 empfängt an seinem Eingang 32 das gefilterte Oszillatorsteuersignal von dem Schleifenfilter 20 und erzeugt an seinem Ausgang 34 ein Ausgangssignal mit einer Ausgangsfrequenz $f_{out}$. Der Oszillator 30 erzeugt das Ausgangssignal so, daß die Ausgangsfrequenz $f_{out}$ von dem gefilterten Oszillatorsteuersignal abhängig ist.

Bei dem Oszillator 30 handelt es sich beispielsweise um einen spannungsgesteuerten Oszillator (VCO; VCO = Voltage Controlled Oscillator). Ein VCO umfaßt in der Regel eine Varaktordiode, deren Kapazität von einer anliegenden Gleichspannung abhängig ist. Die Varaktordiode bildet die Kapazität in einem LC-Schwingkreis. Das gefilterte Oszillatorsteuersignal ist ein Spannungssignal, das an die Varaktordiode (in Sperrichtung) angelegt wird. Je größer die angelegte Spannung ist, desto größer ist die Raumladungszone und desto kleiner ist die elektrische Kapazität zwischen den Elektroden in der Varaktordiode. Je kleiner die Kapazität der Varaktordiode ist, desto größer ist die Eigenfrequenz bzw. Resonanzfrequenz bzw. Ausgangsfrequenz $f_{out}$ des VCO 30.

Ein Frequenzteiler 40 umfaßt einen Eingang 42, der mit dem Ausgang 34 des Oszillators 30 verbunden ist, einen Ausgang 44, der mit dem Vergleichssignaleingang 14 des Phasen/Frequenz-Detektors 10 verbunden ist, und einen Steuereingang 46. Der Frequenzteiler empfängt an seinem Eingang 42 vom Ausgang 34 des Oszillators 30 das Ausgangssignal mit der Ausgangsfrequenz $f_{out}$ und an seinem Steuereingang 46 ein Frequenzfaktorsteuersignal. Das Frequenzfaktorsteuersignal stellt einen Frequenzfaktor dar, der ein ganzzahliger Bruchteil 1/$N$ von 1 ist. Die ganze Zahl $N$ wird im folgenden als Teiler bezeichnet. Der Frequenzteiler 40 erzeugt aus dem Ausgangssignal mit der Ausgangsfrequenz $f_{out}$ durch Frequenzteilung das Vergleichssignal mit der Vergleichsfrequenz $f_1$, wobei die Vergleichsfrequenz $f_1$ um den Frequenzfaktor 1/$N$ kleiner ist als die Ausgangsfrequenz $f_{out}$, $f_1 = f_{out}/N$.

Der in Fig. 10 dargestellte Frequenzgenerator weist ferner einen $\Sigma\Delta$-Modulator 50 auf. Der $\Sigma\Delta$-Modulator 50 umfaßt einen Eingang 52, einen Referenzsignaleingang 54 und einen Steuerausgang 56, der mit dem Steuereingang 46 des Frequenzteilers 40 verbunden ist. Der $\Sigma\Delta$-Modulator empfängt an seinem Eingang 50 ein Signal, das einen erwünschten Frequenzfaktor 1/$N_{frac}$ darstellt, der anders als der vom Frequenzteiler 40 verarbeitete Frequenzfaktor kein ganzzahliger Bruchteil von 1 sein muß. Der $\Sigma\Delta$-Modulator empfängt an seinem Referenzsignaleingang 54 das gleiche Referenzsignal, das auch der Phasen/Detektor-Detektor 10 an seinem Referenzsignaleingang 12 empfängt. Das Referenzsignal dient dem $\Sigma\Delta$-Modulator als Taktsignal.

Der erwünschte Frequenzfaktor $1/N_{frac}$ oder sein Inverses, der erwünschte Teiler $N_{frac}$ werden dem $\Sigma\Delta$-Modulator 50 vorzugsweise in Form eines Eingangswortes $K$ mit der binären Eingangswortbreite k an seinen Eingang 52 übermittelt, wobei $N_{frac} = N_0 + xK/2^k$ gilt. Dabei sind $N_0$ eine natürliche Zahl und $x+1$ die Anzahl der vom Frequenzteiler 40 zur Verfügung gestellten (ganzzahligen) Moduli. Der Frequenzteiler 40 teilt die Ausgangsfrequenz $f_{out}$ durch einen Teiler $N$, der einen der ganzzahligen Werte $N_0$, $N_0+1$, $N_0+2$, ...., $N_0+x$ annimmt. Wenn beispielsweise $f_{ref}$ = MHz, $N_0$ =124 , $x = 2$ und $k = 4$ gilt, können das Eingangswort $K$ die Werte 0, 1, 2, ..., 15, der Teiler $N$ die Werte $N$=124, $N$=125, $N$=126 und der Frequenzfaktor $1/N$ die Werte $1/N$=1/124, $1/N$=1/125 und $1/N$ = 1/126 annehmen.

Wenn der $\Sigma\Delta$-Modulator 50 an seinem Eingang 52 ein Eingangswort $K$ = 0, 1, 2, ..., 15, empfängt, steuert er den Frequenzteiler 40 so, daß der Teiler $N$ im zeitlichen Mittel dem erwünschten Teiler $N_{frac}$, also einem der Werte 124,0, 124,125, 124,250, 124,375, ..., 125,750 bzw. 125,875 entspricht. Wenn der erwünschte Teiler $N_{frac}$ ganzzahlig ist ($K$=0, $N_{frac}$ = 124 und $K$=8, $N_{frac}$ = 125) erzeugt der $\Sigma\Delta$-Modulator 50 an seinem Steuerausgang 56 ein Frequenzfaktorsteuersignal, das bewirkt, daß im Frequenzteiler 40 konstant der entsprechende Frequenzfaktor (1/124 bzw. 1/125) eingestellt ist. Wenn der erwünschte Teiler $N_{frac}$ keine ganze Zahl ist ($K$=1, $N_{frac}$ =124,125 bis $K$=7 , $N_{frac}$ =124,875 und $K$=9, $N_{frac}$ = 125,125 bis $K$ = 1, $N_{frac}$ = 125,875), erzeugt der $\Sigma\Delta$-Modulator 50 an seinem Steuerausgang 56 ein zeitlich veränderliches Frequenzfaktorsteuersignal, das den Frequenzteiler 40 veranlaßt, den Teiler $N$ abwechselnd auf einen der (ganzzahligen) Werte 124, 125, 126 zu setzen. Der $\Sigma\Delta$-Modulator 50 bestimmt dabei die Anteile, welche die einzelnen Frequenzfaktoren an der Gesamtzeit haben, so, daß der zeitliche Mittelwert der von dem Frequenzteiler 40 eingestellten Frequenzfaktoren den erwünschten Frequenzfaktor $1/N_{frac}$ entspricht. Anders ausgedrückt stellt der Gleichanteil des vom $\Sigma\Delta$-Modulator 50 erzeugten Frequenzfaktorsteuersignals sicher, daß die (mittlere) Ausgangsfrequenz des Ausgangssignals $f_{out} = N_{frac}f_{ref}$ beträgt.

Während ohne den $\Sigma\Delta$-Modulator 50 durch den Frequenzteiler 40 lediglich die Ausgangsfrequenzen $f_{out}$ = 992 MHz, 1000 MHz, 1008 MHz einstellbar wären, steuert der $\Sigma\Delta$-Modulator 50 den Frequenzteiler 40 so, daß bei dem genannten Zahlenbeispiel 16 verschiedene Ausgangsfrequenzen im Abstand von 1 MHz erzeugbar sind, $f_{out}$ = 992 MHz ($K$=0), 993 MHz ($K$=1), 994 MHz ($K$=2), ..., 1007 MHz ($K$=15).

Zwischen den Steuerausgang 16 des Phasen/Frequenz-Detektors 10 und den Eingang 22 des Schleifenfilters 20 ist bei dem dargestellten Ausführungsbeispiel eine Schaltung aus zwei Stromquellen 60, 62 und zwei Schaltern 64, 66 geschaltet. Die erste Stromquelle 60, der erste Schalter 64, der zweite Schalter 66 und die zweite Stromquelle 62 sind in dieser Anordnung in Serie zwischen einen Versorgungspotentialanschluß und Masse geschaltet. Die Schalter 64, 66 sind mit dem Steuerausgang 16 des Phasen/Frequenz-Detektor 10 verbunden und werden einzeln und abhängig von der Referenzfrequenz $f_{ref}$ und der Vergleichsfrequenz $f_1$ durch den Phasen/Frequenz-Detektor 10 gesteuert. Sie wandeln das von dem Phasen/Frequenz-Detektor 10 erzeugte Oszillatorsteuersignal in ein modifiziertes Oszillatorsteuersignal, das dem Schleifenfilter 20 zugeführt wird. Funktional kann die Anordnung aus den Stromquellen 60, 62 und den Schaltern 64, 66 als Bestandteil des Phasen/Frequenz-Detektors angesehen werden.

Der Phasen/Frequenz-Detektor 10, das Schleifenfilter 20, der Oszillator und der Frequenzteiler 40 bilden eine Regelschleife. Das von dem Phasen/Frequenz-Detektor 10 aufgrund einer Phasen-Differenz zwischen dem Referenzsignal und dem Vergleichssignal erzeugte Oszillatorsteuersignal steuert den Oszillator 30 so, daß das Vergleichssignal eine konstante Phasenbeziehung zum Referenzsignal aufweist.

Eine weitere wichtige Eigenschaft des $\Sigma\Delta$-Modulators ist, daß er die ganzzahligen Teiler $N$ , $N+1$ , $N+2$ , ..., $N+x$ (bei dem konkreten Zahlenbeispiel: 124, 125, 126) des Frequenzteilers 40 in einer quasi-zufälligen Folge so ansteuert, daß das Quantisierungsrauschen des $\Sigma\Delta$-Modulators 50 ein vorteilhaftes Rauschspektrum aufweist. Dieses vorteilhafte Rauschspektrum enthält bei niedrigen Rauschfrequenzen wenig Leistung und bei hohen Rauschfrequenzen viel Leistung. Diese hohen Rauschfrequenzen werden jedoch durch das Schleiffilter weitgehend unterdrückt bzw. entfernt.

Ein Vorteil des anhand der Fig. 10 beschriebenen $\Sigma\Delta$-Modulator-Fractional-N-Frequenzgenerators bzw. Frequenzgenerators mit dem $\Sigma\Delta$-Modulator ist, daß er mit einer nahezu beliebigen Referenzfrequenz $f_{ref}$ betrieben werden kann bzw. die Referenzfrequenz $f_{ref}$ die Reihe der möglichen Ausgangsfrequenzen $f_{out}$ bzw. deren Frequenzabstand nicht einschränkt. Sein Phasenrauschen und seine Einschwingzeit werden im wesentlichen durch die Übertragungsfunktion $H_{PLL}(s)$ der Phasenregelschleife bestimmt. Der $\Sigma\Delta$-Fractional-N-Frequenzgenerator aus Fig. 10 ist ferner, beispielsweise mittels Preemphase-Verfahren oder Zweipunktmodulation, ohne weiteres modulierbar.

Wenn die Phasenregelschleife 10, 20, 30, 40 und insbesondere ihr Schleifenfilter 20 schmalbandig ist, greift das durch den $\Sigma\Delta$-Modulator 50 bewirkte ständige Umschalten des Frequenzteilers 40 zwischen verschiedenen Frequenzfaktoren $1/N$ bzw. zwischen verschiedenen Teilern $N$ schwächer auf die Ausgangsfrequenz $f_{out}$ durch, als wenn die Phasenregelschleife breitbandig ist. Andererseits ist die Phasenregelschleife um so schneller in der Lage, einer erwünschten Änderung der Ausgangsfrequenz $f_{out}$ zu folgen, je breitbandiger sie ist. Phasenrauschen und Einschwingzeit der Phasenregelschleife und des Frequenzgenerators müssen daher gegeneinander abgewogen werden. Wie schwer es ist, hier einen Kompromiß zu finden, hängt jedoch unter anderem von der Verstärkung $K_{VCO}$ des VCO 30, den Eigenschaften des Phasen/Frequenzdetektors 10 und des Schleifenfilters 20 ab.

Es existiert eine Reihe von Einflüssen auf das Phasenrauschen eines $\Sigma\Delta$-Fractional-N-Frequenzgenerators.

Dazu zählen das Phasenrauschen des freilaufenden Oszillators 30, das Phasenrauschen des Referenzsignals, der Jitter bzw. das Zittern des Frequenzteilers 40, das Rauschen des Phasen/Frequenz-Detektors 10 und des Schleifenfilters 20. Dominant ist in der Regel jedoch das Quantisierungsrauschen $N_q$ des ΣΔ-Modulators 50. D. de Muer und M. S. J. Steyaert geben in ihrem Artikel "A CMOS Monolithic ΣΔ-Controlled Fractional-N Frequency Sythesizer for DCS-1800" (IEEE J. Solid-State Circuits, vol. 37, No. 7, S. 835-44, 2002) eine Näherungsformel für den Beitrag des Quantisierungsrauschens $N_q$ des ΣΔ-Modulators zum Phasenrauschen $S_\phi$ des ΣΔ-Fractional-N-Frequenzgenerators an. Aus dieser Näherungsformel kann man für den Betrag der Übertragungsfunktion die Ungleichung

$$\left| H_{PLL}(2\pi\Delta f_{sp}) \right| < \sqrt{ S_{\phi\max}(\Delta f_{sp}) \frac{3 f_{ref} \left| 1 - z^{-1} \right|^2}{\Delta^2 \pi^2 \left| H_q(z) \right|^2} }$$

herleiten. Wenn diese Ungleichung erfüllt ist, ist das Phasenrauschen $S_\phi$ des Frequenzgenerators bei einer Frequenzablage $\Delta f_{sp}$ vom Träger bzw. einer Trägerfrequenz nicht größer als die Grenze $S_{\phi\max}$. Dabei sind $H_{PLL}(s)$ die Übertragungsfunktion der Phasenregelschleife, $f_{ref}$ die Referenzfrequenz, $H_q(z)$ die rauschformende Funktion des ΣΔ-Modulators, $z = \exp(j2\pi\Delta f_{sp}/f_{ref})$, $\Delta = x/(2^{B-1})$ und $B$ die Breite des Ausgangswortes des ΣΔ-Modulators.

Die Einschwingzeit eines Frequenzgenerators ist definitionsgemäß die Zeit, die der Frequenzgenerator nach der Bekanntgabe der auszugebenden Frequenz benötigt, um die Ausgangsfrequenz $f_{out}$ bis auf einen relativen Fehler α genau einzustellen. Wenn während des Einschwingvorganges die Phasendifferenz zwischen dem Referenzsignal und dem Vergleichssignal kleiner als $2\pi$ bleibt, dann kann der relative Frequenzfehler berechnet werden, indem die Antwort der sogenannten Fehlerübertragungsfunktion $H_e(s) = (1-HPLL(s))$ auf einen Sprung der Höhe $\Delta N_{frac}/N_{frac}$ (zu einem Zeitpunkt $t = 0$) bestimmt wird. Die Einschwingzeit entspricht dann dem frühesten Zeitpunkt, nach dem der Betrag des relativen Frequenzfehlers kleiner als α bleibt.

Das US-Patent Nr. 5,977,838 offenbart eine Hochgeschwindigkeits-PLL-Schaltung und einen Hochgeschwindigkeits-Synthesizer mit einem Schleifenfilter. Das Schleifenfilter ist eine Schaltung mit Kondensatoren in Parallelzweigen und einem Parallelschwingkreis zwischen zwei Parallelzweigen. Das Filter ist vom fünften Grad.

Das US-Patent Nr. 6,008,703 offenbart einen Phasenregelschleifen-Frequenzsynthesizer mit einem Multi-Modulus-Teiler im Rückkopplungszweig, der von einem digitalen Sigma-Delta-Modulator angesteuert wird.

Das US-Patent Nr. 3,740,671 offenbart ein Filter für Phasenregelschleifen dritter Ordnung. Das Schleifenfilter hat eine Übertragungsfunktion, die drei Pole aufweist, die von Schleifenkonstanten abhängen.

Das Datenblatt "MAX260/MAX261/MAX262 Micropocessor Programmable Universal Active Filters", MAXIM Integrated Products USA, 2002 offenbart universelle Switch-Capacitor-Aktivfilter, die universell einsetzbar sind, wie beispielsweise für Phasenregelschleifen.

Die Aufgabe der vorliegenden Erfindung besteht darin, einen Frequenzgenerator zu schaffen, der ein geringes Phasenrauschen und eine kurze Einschwingzeit aufweist.

Diese Aufgabe wird durch einen Frequenzgenerator nach Anspruch 1 gelöst.

Die vorliegende Erfindung beruht auf der Idee, ein Schleifenfilter zu verwenden, dessen Übertragungsfunktion ein Paar konjugiert komplexer Pole aufweist. Ferner beruht die vorliegende Erfindung auf der Erkenntnis, das diese konjugiert komplexen Pole so gewählt werden können, daß das Phasenrauschen $S_\phi$ des Frequenzgenerators bei einer bestimmten Frequenzablage vom Träger eine vorbestimmte Grenze nicht überschreitet und gleichzeitig die Einschwingzeit des Frequenzgenerators minimiert ist.

Gemäß einem bevorzugten Ausführungsbeispiel der vorliegenden Erfindung wird ein Frequenzgenerator mit einer Phasenregelschleife entworfen. Dazu werden als Lösung der beschriebenen Minimierungsaufgabe mit Randbedingungen zunächst Pole und Nullstellen der Übertragungsfunktion der Phasenregelschleife bestimmt. Aus den Polenund Nullstellen der Übertragungsfunktion der Phasenregelschleife können dann die Übertragungsfunktion des Schleifenfilters und deren Paar konjugiert komplexer Pole bestimmt werden.

Ein Vorteil der vorliegenden Erfindung besteht darin, daß sie einen optimalen und insbesondere gegenüber dem Stand der Technik stark verbesserten Kompromiß zwischen Phasenrauschen und Einschwingzeit einer Phasenregelschleife eines Frequenzgenerators schafft.

Gemäß bevorzugten Ausführungsbeispielen der vorliegenden Erfindung umfaßt das Schleifenfilter eine Spule oder ein aktives Filter, um ein Paar konjugiert komplexer Pole der Übertragungsfunktion zu erzeugen. Besonders bevorzugt umfaßt das Schleifenfilter ein Biquad-Filter oder ein Current-Mode-Biquad-Filter. Das Current-Mode-Biquad-Filter ist vorzugsweise aus Transkonduktoren aufgebaut. Ein Vorteil der Realisierung des Schleifenfilters mit einem Current-Mode-Biquad-Filter besteht darin, daß dieses einen besonders geringen Leistungsbedarf aufweist.

Vorzugsweise wird das Schleifenfilter aus Transkonduktoren synthetisiert. Dies hat den Vorteil, daß die einzelnen Transkonduktoren sich gegenseitig nur geringfügig beeinflussen. Anders als beispielsweise bei der Verwendung passiver Bauelemente wie Widerstände, Kondensatoren und Spulen, zur Synthese eines Filters ist der Syntheseprozeß bei Verwendung von Transkonduktoren relativ linear und unkompliziert.

Nachfolgend werden bevorzugte Ausführungsbeispiele der vorliegenden Erfindung mit Bezug auf die beiliegenden Figuren näher erläutert. Es zeigen:

Fig. 1    ein schematisches Diagramm, das die Einschwingzeit eines erfindungsgemäßen Frequenzgenerators darstellt;

Fig. 2    ein schematisches Schaltungsdiagramm eines Schleifenfilters gemäß einem bevorzugten Ausführungsbeispiel der vorliegenden Erfindung;

Fig. 3    ein schematisches Blockschaltbild eines Biquad-Filters eines Schleifenfilters gemäß der vorliegenden Erfindung;

Fig. 4    einen Current-Mode-Integrator eines Schleifenfilters gemäß der vorliegenden Erfindung;

Fig. 5    ein Current-Mode-Biquad-Filter eines Schleifenfilters gemäß einem bevorzugten Ausführungsbeispiel der vorliegenden Erfindung;

Fig. 6    ein schematisches Schaltungsdiagramm eines Transkonduktors aus Fig. 5;

Fig. 7    ein schematisches Schaltungsdiagramm einer Ausgangsgleichtaktregelung für den Transkonduktor aus Fig. 6;

Fig. 8    eine schematische Darstellung der Übertragungsfunktion eines Transkonduktors;

Fig. 9    eine schematische Darstellung der Übertragungsfunktion eines Biquad-Filters; und

Fig. 10    ein schematisches Schaltungsdiagramm eines herkömmlichen Frequenzgenerators mit einer Phasenregelschleife.

Wie bereits erläutert wurde, sind sowohl die Einschwingzeit $T_{min}$ als auch das Phasenrauschen $S_\phi$ des Frequenzgenerators Funktionen der Pole und Nullstellen der Übertragungsfunktion $H_{PLL}(s)$ der Phasenregelschleife. Die Übertragungsfunktion $H_{PLL}(s)$ der Phasenregelschleife hängt von der Verstärkung $K_{VCO}$ des Oszillators 30 (Fig. 10), von dem Strom $I_p$ des von den Stromquellen betriebenen Stromes und von der Übertragungsfunktion $Z_{LF}(s)$ des Schleifenfilters 20 wie folgt ab:

$$H_{PLL}(s) = \frac{\dfrac{K_{VCO}I_p}{2\pi}Z_{LF}(s)}{1+\dfrac{K_{VCO}I_p}{2\pi}Z_{LF}(s)}$$

(vgl. F. M. Gardner: "Charge-Pump Phase-Lock Loops", IEEE Trans. Commun., vol. COM-28, S. 1849-58, 1980). Die Übertragungsfunktion eines Schleifenfilters einer Phasenregelschleife vom Typ II $N$-ter Ordnung hat $N$-2 von Null verschiedene Pole $s_{\infty LF,n}$ und eine Nullstelle. Zusammen mit dem Faktor $K_{VCO}I_p$ existieren also $N$ unabhängige Variable, die sich eineindeutig auf die Pole $s_{\infty PLL,n}$ der Übertragungsfunktion $H_{PLL}(s)$ der Phasenregelschleife abbilden lassen. Die Pole $s_{\infty PLL,n}$ ($n$=1, 2, ..., $N$) werden dargestellt als

$$s_{\infty PLL,n} = s_N s_{\infty r,n},$$

wobei $s_N$ ein Referenzort auf dem negativen Abschnitt der reellen Achse der komplexen Zahlenebene und $s_{\infty r,n}$ ($n$=1, 2, ..., $N$) die relativen Orte von deren Pole in der komplexen Zahlenebene bezogen auf den Referenzort $s_N$ sind.

Die Übertragungsfunktion $H_{o,PLL}(s)$ der offenen Phasenregelschleife vom Typ II ist eine einfache Funktion der Transimpedanz $Z_{LF}(s)$ des Schleifenfilters,

$$H_{o,PLL}(s) = \frac{K_{VCO}I_p}{N_{frac}2\pi s} Z_{LF}(s) \ .$$

Die Transimpedanz $Z_{LF}(s)$ des Schleifenfilters wird dargestellt als Bruch $Z_{LF}(s) = P_{LF}(s)/Q_{LF}(s)$ zweier Polynome

$$P_{LF}(s) = p_{1,LF}s + p_{0,LF}$$

und

$$Q_{LF}(s) = q_{N-1,LF}s^{N-1} + q_{N-2,LF}s^{N-2} + \ldots + q_{1,LF}s \ .$$

Der Zusammenhang zwischen der Übertragungsfunktion $H_{PLL}(s)$ der geschlossenen Phasenregelschleife und der Übertragungsfunktion $H_{o,PLL}(s)$ der offenen Phasenregelschleife ist

$$H_{PLL}(s) = \frac{P_{PLL}(s)}{Q_{PLL}(s)} = \frac{H_{o,PLL}(s)}{1 + H_{o,PLL}(s)} \ .$$

Die Koeffizienten $p_{n,LF}$ ($n = 0, 1$) des Zählerpolynoms $P_{LF}(s)$ und $q_{n,LF}$ ($n = 1, 2, \ldots, N\text{-}1$) des Nennerpolynoms $Q_{LF}(s)$ des Schleifenfilters können wie folgt einfach aus den Koeffizienten $q_{n,PLL}$ ($n = 0, 1, 2, \ldots, N$) des Nennerpolynoms $Q_{PLL}(s)$ der Übertragungsfunktion $H_{PLL}(s)$ der Phasenregelschleife bestimmt werden:

$$p_{n,LF} = \frac{2\pi N_{frac}}{K_{VCO}I_p} q_{n,PLL} \quad (n = 0, 1)$$

und

$$q_{n,LF} = q_{n+1,PLL} \quad (n = 1, 2, \ldots, N-1) \ .$$

Aus den Gleichungen folgt, daß sowohl das Zählerpolynom $P_{LF}(s)$ als auch das Nennerpolynom $Q_{LF}(s)$ der Übertragungsfunktion $Z_{LF}(s)$ des Schleifenfilters als auch das Produkt $K_{VCO}I_p/N_{frac}$ alleine aus dem Nennerpolynom $Q_{PLL}(s)$ der Übertragungsfunktion $H_{PLL}(s)$ der Phasenregelschleife berechnet werden können. Ferner folgt aus den Gleichungen, daß die Übertragungsfunktion $H_{PLL}(s)$ der Phasenregelschleife genau eine Nullstelle bei $s_0 = q_{1,PLL}/q_{0,PLL}$ aufweist. Diese Nullstelle wird nicht unabhängig von den Polen der Übertragungsfunktion $H_{PLL}(s)$ der Übertragungsfunktion der Phasenregelschleife eingestellt. Die Kenntnis der Pole $s_{\infty PLL,n}$ ($n = 1, 2, \ldots, N$) der Übertragungsfunktion $H_{PLL}(s)$ der Phasenregelschleife oder von deren relativen Orten $s_{\infty r,n}$ ist deshalb ausreichend, um die Übertragungsfunktion $H_{PLL}(s)$ für ein beliebiges $s$ zu bestimmen .

Bei einem ersten Syntheseschritt wird derjenige Referenzort $s_N$ ermittelt, für den die obige Ungleichung mit dem Gleichheitszeichen erfüllt ist,

$$\left| H_{PLL}(2\pi\Delta f_{sp}) \right| = \sqrt{ S_{\phi\max}(\Delta f_{sp}) \frac{3 f_{ref} \left| 1 - z^{-1} \right|^2}{\Delta^2 \pi^2 \left| H_q(z) \right|^2} } \ .$$

Laut Ähnlichkeitssatz der Laplace-Transformation minimiert die Lösung dieser Gleichung die Einschwingzeit der Phasenregelschleife für gegebene relative Orte $s_{\infty r,n}$ ($n$=1, 2, ... , $N$) der Pole.

Derjenige Satz von relativen Pol-Orten $s_{\infty r,n}$, für den bei dem optimierten Referenzort $s_N$ die Einschwingzeit $T$ minimal ist ($T = T_{min}$), wird anschließend mit einem numerischen Verfahren gesucht. Ein solches numerisches Verfahren ist beispielsweise der Nelder-Mead-Algorithmus (J.C. Lagarias et al.: "Convergence Properties of The Nelder-Mead Simplex-Method in Low Dimension", SIAM J. Optim, Vol. 9, no.1, S112-47, 1998). Der Nelder-Mead-Algorithmus ist unter anderem in MatLab verfügbar.

Zwischen den Koeffizienten $q_{n,PLL}$ ($n$ = 0, 1, ... , $N$) des Nennerpolynoms $Q_{PLL}(s)$ der Übertragungsfunktion $H_{PLL}(s)$ der Phasenregelschleife einerseits und den Nullstellen $s_{\infty PLL,n} = s_N s_{\infty r,n}$ ($n$ = 1, 2, ... , $N$) des Nennerpolynoms $Q_{PLL}(s)$ d. h. den Polen der Übertragungsfunktion $H_{PLL}(s)$ andererseits besteht ein einfacher Zusammenhang, der durch Ausmultiplizieren der rechten Seite der Gleichung

$$Q_{LF}(s) = q_{N-1,LF} s^{N-1} + q_{N-2,LF} s^{N-2} + \ldots + q_{1,LF} s = (s - s_{\infty PLL,1}) \cdot (s - s_{\infty PLL,2}) \cdot \ldots \cdot (s - s_{\infty PLL,N})$$

ohne weiteres zu erhalten ist. Auf diese Weise werden aus den optimierten Polen $s_{\infty PLL,n} = s_N s_{\infty r,n}$ ($n$ = 1, 2, ... , $N$) der Übertragungsfunktion $H_{PLL}(s)$ die Koeffizienten $q_{n,PLL}$ ($n$ = 0, 1, ... , $N$) des Nennerpolynoms $Q_{PLL}(s)$ der Übertragungsfunktion $H_{PLL}(s)$ der Regelschleife gewonnen.

Aus den Koeffizienten $q_{n,PLL}$ ($n$ = 0, 1, ..., $N$) des Nennerpolynoms $Q_{PLL}(s)$ der Übertragungsfunktion $H_{PLL}(s)$ der Regelschleife werden gemäß den oben bereits angegebenen Gleichungen

$$p_{n,LF} = \frac{2\pi N_{frac}}{K_{VCO} I_p} q_{n,PLL} \quad (n = 0, 1)$$

und

$$q_{n,LF} = q_{n+1,PLL} \quad (n = 1, 2, \ldots, N-1).$$

die Koeffizienten $p_{n,LF}$ ($n$ = 0, 1) des Zählerpolynoms $P_{LF}(s)$ und die Koeffizienten $q_{n,LF}$ ($n$ = 1, 2, ..., $N$-1) des Nennerpolynoms $Q_{LF}(s)$ der Übertragungsfunktion des Schleifenfilters gewonnen.

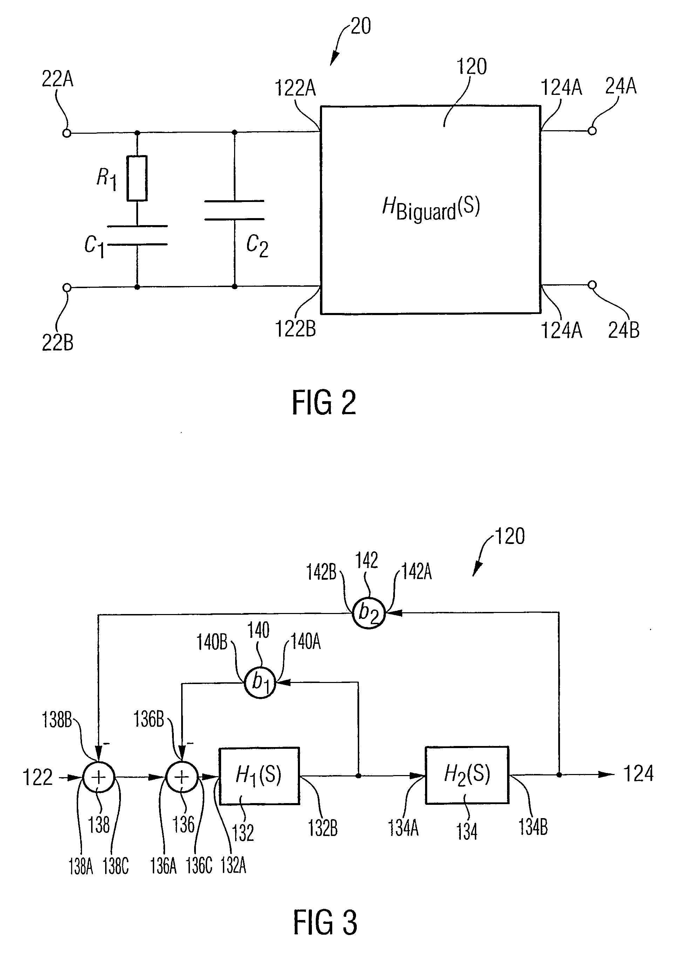

Damit sind das Schleifenfilter bzw. die Koeffizienten seiner mathematischen Darstellung vollständig bestimmt. Die Berechnung der Größen einzelner Bauteile wird weiter unten anhand der Fig. 2 bis 5 beipielhaft näher beschrieben.

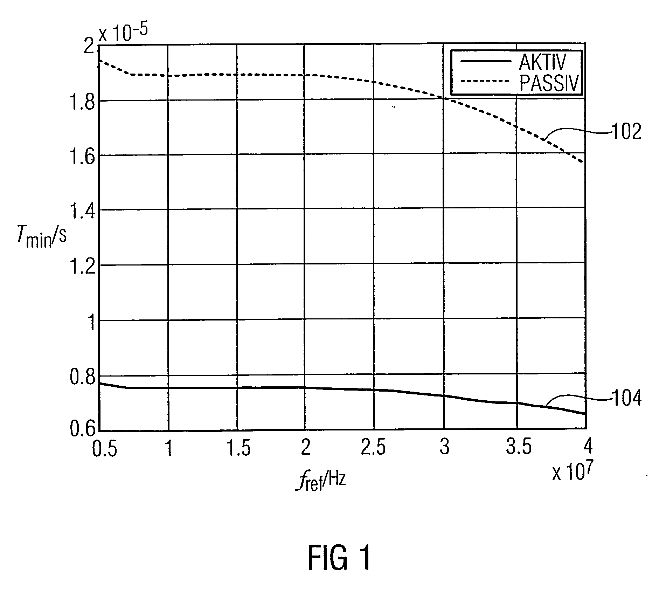

Fig. 1 zeigt in einem schematischen Diagramm die minimalen Einschwingzeiten $T_{min}$ (Ordinate) für Phasenregelschleifen mit einem herkömmlichen passiven Schleifenfilter (Kurve 102, punktiert) und mit dem erfindungsgemäßen aktiven Schleifenfilter (Kurve 104, durchgezogen) in Abhängigkeit von der Referenzfrequenz $f_{ref}$ (Abszisse). Bei der herkömmlichen Phasenregelschleife mit einem passiven Schleifenfilter handelt es sich um eine Phasenregelschleife vom Typ II 5-ter Ordnung. Beide Kurven 102, 104 wurden gerechnet für ein Phasenrauschen von -125 dBc/Hz@2,5MHz einen Modulussprung von $\Delta N_{frac}/N_{frac}$ =1/30, $\Delta = x/(2^{B-1}) = 2$ und eine Frequenzgenauigkeit von $\alpha$ = 20 ppm. Es ist erkennbar, daß über den gesamten dargestellten Bereich der Referenzfrequenz $f_{ref}$ die Einschwingzeit für die herkömmliche Phasenregelschleife mit einem passiven RC-Schleifenfilter mehr als doppelt so hoch ist wie für die erfindungsgemäße Phasenregelschleife mit einem Paar konjugiert komplexer Pole, die wie oben angegeben optimiert wurden.

Fig. 2 zeigt ein schematisches Schaltungsdiagramm eines Schleifenfilters 20 gemäß einem bevorzugten Ausführungsbeispiel der vorliegenden Erfindung. Das Schleifenfilter 20 ist ein Filter vierter Ordnung mit zwei reellen Polen und einem Paar konjugiert komplexer Pole. Die reellen Pole werden mit Hilfe eines passiven RC-Filters aus einem Widerstand $R_1$ und zwei Kondensatoren $C_1$, $C_2$ realisiert. Der Widerstand $R_1$ und der erste Kondensator $C_1$ sind in Serie zwischen die Eingänge 22a, 22b und des Schleifenfilter 20 geschaltet. Parallel zu der Serienschaltung aus dem Wider-

stand $R_1$ und dem ersten Kondensator $C_1$ ist der zweite Kondensator $C_2$ zwischen die Eingänge 22a, 22b geschaltet. Dem passiven RC-Filter aus dem Widerstand $R_1$ und den Kondensatoren $C_1$, $C_2$ ist ein Biquad-Filter 120 nachgeschaltet, wobei Eingänge 122a, 122b des Biquad-Filters 120 mit den Eingängen 22a, 22b des Schleifenfilters 20 verbunden sind. Ausgänge 124a, 124b des Biquad-Filters 120 sind mit den Ausgängen 24a, 24b des Schleifenfilters 20 verbunden. Die Übertragungsfunktion $H_{Biquad}(s)$ des Biquad-Filters 120 weist das Paar konjugiert komplexer Pole auf.

Fig. 3 ist ein schematisches Blockschaltbild, des Biquad-Filter 120 aus Fig. 2. Das Biquad-Filter 120 umfaßt einen ersten Integrator 132 mit der Übertragungsfunktion $H_1(s)$, einen zweiten Integrator 134 mit der Übertragungsfunktion $H_2(s)$, einen ersten Addierer 136, einen zweiten Addierer 138, einen ersten Multiplizierer 140 und einen zweiten Multiplizierer 142. Ein erster Eingang 138a des zweiten Addierers 138 ist mit dem Eingang 122 des Biquad-Filters 120 verbunden. Ein zweiter Eingang 138b des zweiten Addierers 138 ist mit einem Ausgang 142b des zweiten Multiplizierers 142 verbunden. Ein Ausgang 138c des zweiten Addierers 138 ist mit einem ersten Eingang 136a des ersten Addierers 136 verbunden. Ein zweiter Eingang 136b des ersten Addierers 136 ist mit einem Ausgang 140b des ersten Multiplizierers 140 verbunden. Ein Ausgang 136c des ersten Addierers 136 ist mit einem Eingang 132a des ersten Integrators 132 verbunden. Ein Ausgang 132b des ersten Integrators 132 ist mit einem Eingang 140a des ersten Multiplizierers 140 und mit einem Eingang 134a des zweiten Integrators 134 verbunden. Ein Ausgang 134b des zweiten Integrators 134 ist mit einem Eingang 142a des zweiten Multiplizierers 142 und dem Ausgang 124 des Biquad-Filters 120 verbunden.

In einer idealisierten Näherung sind die Integratoren 132, 134 ideale Integratoren, deren Übertragungsfunktionen $H_{1,ideal}(s)$, $H_{2,ideal}(s)$ die einfachen Formen

$$H_{1,ideal}(s)\frac{a_1}{s}$$

und

$$H_{2,ideal}(s)\frac{a_2}{s}$$

aufweisen. Damit gilt

$$H_{Biquad,ideal}(s) = \frac{K}{s^2 + \dfrac{\omega_0}{Q}s + \omega_0^2} = \frac{a_1 a_2}{s^2 + a_1 b_1 s + a_1 a_2 b_2} \, ,$$

wobei Q die Güte und $\omega_0$ die Resonanzfrequenz des Biquad-Filters 120 sind.

Ideale Integratoren existieren jedoch nicht. In einer ersten Annäherung an die Realität werden die Pole der Übertragungsfunktionen $H_1(s)$, $H_2(s)$ aus dem Ursprung entlang der reellen Achse in der komplexen Zahlenebene verschoben,

$$H_1(s)\frac{a_1}{s + s_{\infty 1}}$$

und

$$H_2(s)\frac{a_2}{s + s_{\infty 3}}$$

Damit gilt

$$H_{Biquad}(s) = \frac{a_1 a_2}{s^2 + (a_1 b_1 + s_{\infty 1} + s_{\infty 3})s + a_1 a_2 b_2 + a_1 b_1 s_{\infty 3} + s_{\infty 1} s_{\infty 3}}$$

Aus dieser Gleichung ist erkennbar, bzw. ableitbar, daß die Güte Q des Biquad-Filters anders als im Fall idealer Integratoren nach oben begrenzt ist. Ferner sind die Resonanzfrequenz $w_0$ nach unten beschränkt und die Gleichstromverstärkung verringert, und zwar um so stärker, je näher die Polfrequenz der Integratoren 132, 134 der angestrebten Resonanzfrequenz liegt.

Aus einem Vergleich mit der oben bereits angegebenen Gleichung

$$Q_{LF}(s) = q_{N-1,LF}s^{N-1} + q_{N-2,LF}s^{N-2} + \ldots + q_{1,LF}s$$

für das Nennerpolynom der Übertragungsfunktion $Z_{LF}(s)$ des Schleifenfilters ergeben sich einfache Zusammenhänge zwischen den nach dem oben beschriebenen Verfahren bestimmten Koeffizienten $q_{n,LF}$ ($n = 0, 1, 2$) des Nennerpolynoms $Q_{LF}(s)$ der Übertragungsfunktion $Z_{LF}(s)$ des Schleifenfilters und den Koeffizienten $a_1$, $a_2$, $s_{\infty 1}$, $s_{\infty 3}$ der Übertragungsfunktionen $H_1(s)$, $H_2(s)$ der (nicht idealen) Integratoren, aus denen das Biquad-Filter in diesem Ausführungsbeispiel aufgebaut ist:

$$q_{2,LF} = 1 \,,$$

$$q_{1,LF} = a_1 b_1 + s_{\infty 1} + s_{\infty 3} \,,$$

$$q_{0,LF} = a_1 a_2 b_2 + a_1 b_1 s_{\infty 3} + s_{\infty 1} s_{\infty 3}$$

Über die Tatsache, daß der Pol der Übertragungsfunktion eines realen Integrators nicht im Ursprung liegen kann, hinaus, ist die reale Übertragungsfunktion eines realen Integrators mit zusätzlichen parasitären Polen und Nullstellen versehen.

Häufige, bzw. übliche Anforderungen an mikroelektronische Filter sind eine geringe Stromaufnahme bzw. ein geringer Leistungsbedarf, ein geringes Rauschen und eine ausreichende Linearität. Zur Erfüllung dieser Anforderungen wird das Biquad-Filter 120 aus Fig. 2 und 3 vorzugsweise gemäß der Current-Mode-Technik aufgebaut, die beispielsweise in dem Artikel "Accurate CMOS Current-Mode-Filters for High Frequencies and Low Power Consumption" von N. Christoffers quencies and Low Power Consumption" von N. Christoffers et al. (Konferenzband der ANALOG'02, S. 343-48, Bremen 2002) beschrieben ist. Das Eingangs-Spannungssignal $U_{in}(s)$ eines Current-Mode-Biquad-Filters wird zunächst durch einen Transkonduktor mit der Transkonduktanz $G_m$ in einen Strom $I_{in}(s)=G_m U_{in}(s)$ gewandelt. Durch eine Filterung, die durch die Übertragungsfunktion $H_{Biquad}(s)$ des Biquad-Filters beschrieben wird, wird dann aus dem Strom-Eingangssignal $I_{in}(s)$ ein Strom-Ausgangssignal $I_{out}(s)=H_{Biquad}(s)I_{in}(s)$ bestimmt bzw. berechnet. Die Ausgangsspannung $U_{out}(s)$ folgt aus dem Ausgangsstrom $I_{in}(s)$ durch erneute Wandlung, $U_{out}(s) = I_{out}(s)/G_m = H_{Biquad}(s)U_{in}(s)$.

In der Current-Mode-Technik sind die Ein- und Ausgangssignale der Integratoren Ströme. Deshalb können die Summationsstellen, bzw. die Addierer 136, 138 zu einfachen Schaltungsknoten vereinfacht werden. Entsprechend der Kirchhoff'schen Knotenregel folgt eine lineare, rauschfreie und frequenzunabhängige Summation ohne einen zusätzlichen Leistungsbedarf.

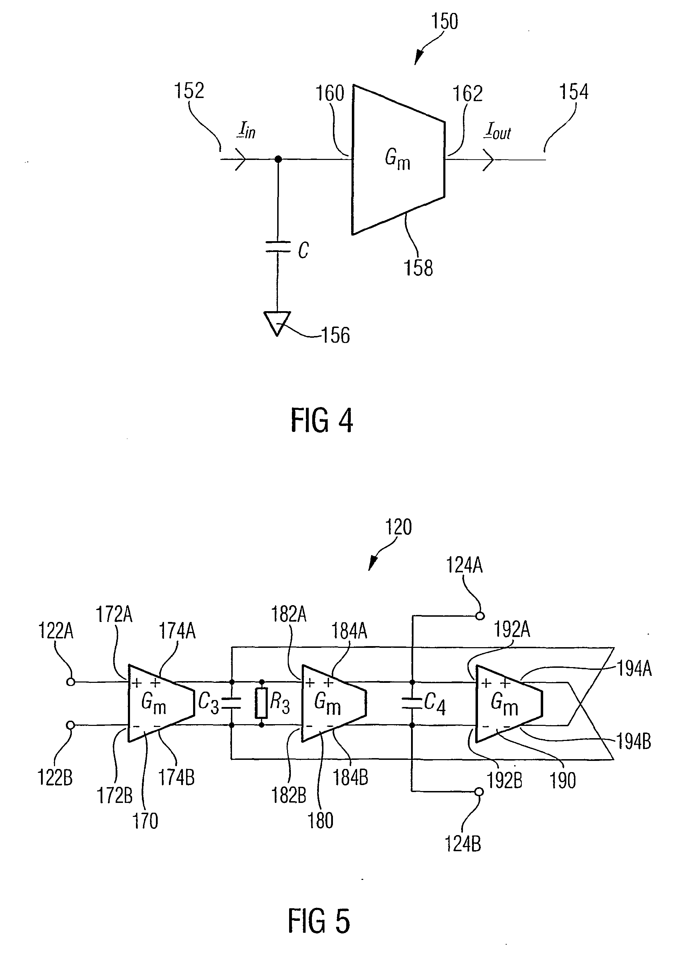

Fig. 4 zeigt ein schematisches Schaltungsdiagramm eines Integrators 150 mit einem Eingang 152 und einem Ausgang 154 in Current-Mode-Technik. Der Integrator 150 umfaßt einen Kondensator $C$, der zwischen dem Eingang 152 und Masse 156 geschaltet ist. Der Integrator 150 umfaßt ferner einen Transkonduktor 158 mit einer Transkonduktanz $G_m$, der zwischen den Eingang 152 und den Ausgang 154 des Integrators 150 geschaltet ist, das heißt ein Eingang des Transkonduktors 158 ist mit dem Eingang 152 des Integrators 150 und dem Kondensator $C$ verbunden und ein Ausgang 162 des Transkonduktors 158 ist mit dem Ausgang 154 des Integrators 150 verbunden. Im Fall eines idealen Transkonduktors 158 gilt dann für den Zusammenhang und zwischen dem Eingangsstrom $I_{in}$ und dem Ausgangsstrom $I_{out}$

$$I_{out}(s) = \frac{G_m}{C} \frac{I_{in}(s)}{s} \;.$$

Fig. 5 ist ein schematisches Schaltungsdiagramm des Biquad-Filters 120 in Current-Mode-Technik. Das Biquad-Filter 120 umfaßt einen ersten Transkonduktor 170 mit Eingängen 172a, 172b, die mit den Eingängen 122a, 122b des Biquad-Filters 120 verbunden sind und Ausgängen 174a, 174b. Ein zweiter Transkonduktor 180 umfaßt Eingänge 182a, 182b, die mit den Ausgängen 174a, 174b des ersten Transkonduktors 170 verbunden sind, sowie Ausgänge 184a, 184b. Ein dritter Transkonduktor 190 umfaßt Eingänge 192a, 192b, die mit den Ausgängen 184a, 184b des zweiten Transkonduktors 180 und den Ausgängen 124a, 124b des Biquad-Filters verbunden sind, und Ausgänge 194a, 194b, die gekreuzt den Ausgängen 174a, 174b des ersten Transkonduktors 170 und den Eingängen 182a, 182b des zweiten Transkonduktors verbunden sind. Ferner umfaßt das Biquad-Filter 120 einen dritten Kondensator $C_3$ dessen erste Elektrode mit dem ersten Ausgang 174a des ersten Transkonduktors 170, dem ersten Eingang 182a des zweiten Transkonduktors 180 und dem zweiten Ausgang 194b und des dritten Transkonduktors 190 verbunden ist, und dessen zweite Elektrode mit dem zweiten Ausgang 174b des ersten Transkonduktors 170, dem zweiten Eingang 182b des zweiten Transkonduktors 180 und dem ersten Ausgang 194a des dritten Transkonduktors 190 verbunden ist. Ferner umfaßt das Biquad-Filter 120 einen Widerstand $R_3$, der parallel zu dem dritten Kondensator $C_3$ geschaltet ist. Ferner umfaßt Biquad-Filter 120 einen vierten Kondensator $C_4$, dessen erste Elektrode mit dem ersten Ausgang 184a des zweiten Transkonduktors 180, dem zweiten Eingang 192a des dritten Transkonduktors 190 und dem ersten Ausgang 124a des Biquad-Filters 120 verbunden ist, und dessen zweite Elektrode mit dem zweiten Ausgang 184b des zweiten Transkonduktors 180, dem zweiten Eingang 192b des dritten Transkonduktors 190 und dem zweiten Ausgang 124b des Biquad-Filters 120 verbunden ist.

Alle drei Transkonduktoren 170, 180, 190 weisen vorzugsweise so, wie es in Fig. 5 gezeigt ist, die gleiche Transkonduktanz $G_m$ auf. Für die Koeffizienten $a_1$, $a_2$, $b_1$, $b_2$ in den oben angegebenen Formeln für die Übertragungsfunktion $H_1(s)$, $H_2(s)$ der in Fig. 3 dargestellten Integratoren 132, 134 und in der Übertragungsfunktion $H_{Biquad}(s)$ des Biquad-Filters 120 gilt $a_1 = G_m/C_3$, $a_2 = G_m/C_4$, $b_1 = 1/(G_m R_3)$ und $b_2 = 1$. Ferner gilt

$$K = \omega_0 = \frac{G_m}{\sqrt{C_3 C_4}}$$

und

$$Q = R_3 C_3 \omega_0 \;.$$

Die maximal erzielbare Gleichstrom-Verstärkung des Current-Mode-Biquad-Filters beträgt 1. Da in der Realität sowohl $s_{\infty 1}$ als auch $s_{\infty 3}$ endlich sind ($s_{\infty 1} > 0$, $s_{\infty 3} > 0$) , dämpft das Biquad-Filter 120 ein dieses durchlaufendes Signal und verschlechtert dessen Signal-zu-Rausch-Verhältnis. Bei einem endlichen Ausgangswiderstand $R_{out}$ von jedem der drei Transkonduktoren 170, 180, 190 gilt

$$s_{\infty 1} = \frac{1}{R_{out} C_3} \quad \text{und} \quad s_{\infty 3} = \frac{1}{R_{out} C_4} \;.$$

Um die Dämpfung eines das Biquad-Filter 120 durchlaufenden Signals und die Verschlechterung des Signal-zu-Rausch-Verhältnisses zu minimieren, wird folglich ein möglichst großer Ausgangswiderstand $R_{out}$ verwendet.

Setzt man obige Identitäten für die Koeffizienten $a_1$, $a_2$, $b_1$, $b_2$ in die oben angegebenen mathematischen Zusammenhänge zwischen den nach dem oben beschriebenen Verfahren bestimmten Koeffizienten $q_{n,LF}$ ($n = 0, 1, 2$) des Nennerpolynoms $Q_{LF}(s)$ der Übertragungsfunktion $Z_{LF}(s)$ des Schleifenfilters und den Koeffizienten $a_1$, $a_2$, $b_1$, $b_2$ der Übertragungsfunktionen $H_1(s)$, $H_2(s)$ der Integratoren

$$q_{2,LF} = 1 \, ,$$

$$q_{1,LF} = a_1 b_1 + s_{\infty 1} + s_{\infty 3} \, ,$$

$$q_{0,LF} = a_1 a_2 b_2 + a_1 b_1 s_{\infty 3} + s_{\infty 1} s_{\infty 3}$$

ein, so erhält man die Gleichungen

$$q_{2,LF} = 1 \, ,$$

$$q_{1,LF} = \frac{G_m}{C_3} \frac{1}{G_m R_3} + \frac{1}{R_{out} C_3} + \frac{1}{R_{out} C_4} = \frac{1}{C_3 R_3} + \frac{1}{R_{out} C_3} + \frac{1}{R_{out} C_4}$$

$$q_{0,LF} = \frac{G_m}{C_3} \frac{G_m}{C_4} + \frac{G_m}{C_3} \frac{1}{G_m C_3} \frac{1}{R_{out} C_4} + \frac{1}{R_{out} C_3} \frac{1}{R_{out} C_4} = \frac{G_m^2}{C_3 C_4} + \frac{1}{C_3^2 R_{out} C_4} + \frac{1}{R_{out}^2 C_3 C_4}$$

Diese Gleichungen schaffen einen direkten Zusammenhang zwischen den wie oben beschrieben gewonnenen Koeffizienten $q_{0,LF} = 1$, $q_{1,LF} = 1$, $q_{2,LF}$ des Nennerpolynoms $Q_{LF}(s)$ der Übertragungsfunktion $Z_{LF}(s)$ des Schleifenfilters einerseits und der Transkonduktanz $G_m$ der Transkonduktoren und den Widerständen $R_3$, $R_4$, $R_{out}$ und Kapazitäten $C_3$, $C_4$ andererseits. In einem letzten Syntheseschritt werden somit aus diesen Gleichungen und den Gleichungen

$$K = \omega_0 = \frac{G_m}{\sqrt{C_3 C_4}}$$

und

$$Q = R_3 C_3 \omega_0 \, .$$

die Bauelementgrößen $G_m$, $R_3$, $R_4$, $R_{out}$, $C_3$, $C_4$ zum Aufbau des erfindungsgemäßen Biquad-Filters gewonnen.
Typische Bauelementgrößen der Bauelemente aus den Fig. 2 bis 6 sind: $G_m$ 7,5 $\mu$S, $R_1$ = 66,3 kΩ, $R_3$ =137 kΩ, $R_T$ =100 kΩ, $C_1$ =118 pF, $C_2$ = 14 pF, $C_3 = C_4$ =7,5 pF. Die Polgüte liegt typischerweise in der Größernordnung von 0,1 bis 1, die Polfrequenz liegt typischerweise im Bereich einiger 10 kHz.

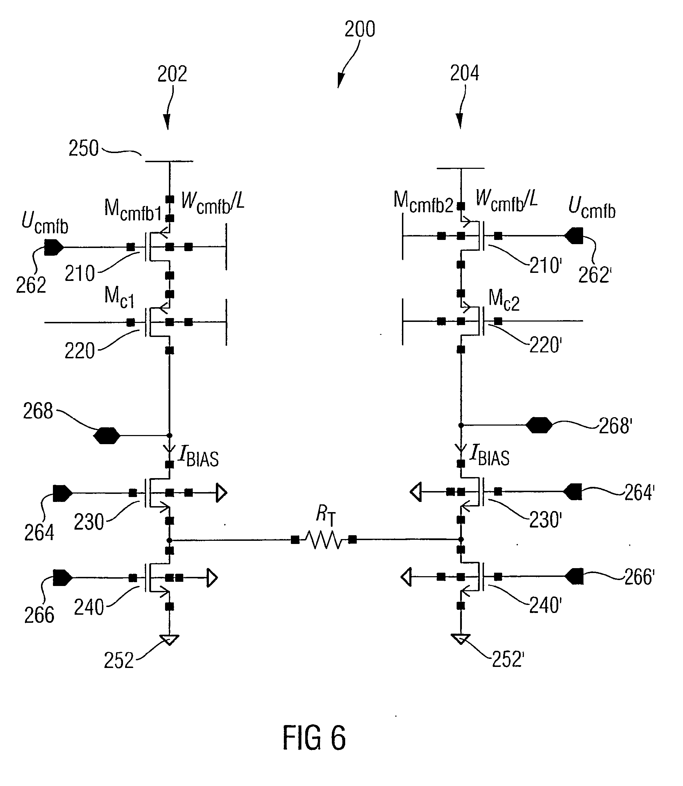

Fig. 6 ist ein schematisches Schaltungsdiagramm, das einen Transkonduktor 200 gemäß einem bevorzugten Ausführungsbeispiel der vorliegenden Erfindung zeigt. Der Transkonduktor 200 ist beispielsweise als einer der Transkonduktoren 170, 180, 190 aus Fig. 5 verwendbar. Der Transkonduktor 200 ist nach dem Prinzip eines degenerierten Differenzverstärkers aufgebaut. Um Kondensatoren $C_3$, $C_4$ mit möglichst kleinen Kapazitäten und deshalb möglichst kleinem Platzbedarf in einer integrierten Schaltung verwenden zu können, wird eine Transkonduktanz $G_m$ im Bereich weniger $\mu$S angestrebt. So niedrige Transkonduktanzen sind mit Transistoren in starker Inversion nur schwer erreichbar. Transistoren in schwacher Inversion verfügen nur über kleine Ausgangswiderstände und sind deshalb im Rahmen der vorliegenden Aufgabenstellung ungeeignet. Statt dessen wird eine hohe Transkonduktanz $g_m$ der verwendeten Transistoren eingestellt. Mit Hilfe einer negativen Rückkoppelung durch einen Widerstand $R_T$ wird die Transkonduktanz $G_m$ des Transkonduktors 200 zu

$$G_m = \frac{g_m}{1 + R_T(g_m + g_{mbs})}$$

festgelegt, wobei $g_{mbs}$ die Bulk-Source-Transkonduktanz des Transistors in Folge des Substrat-Effekts ist.

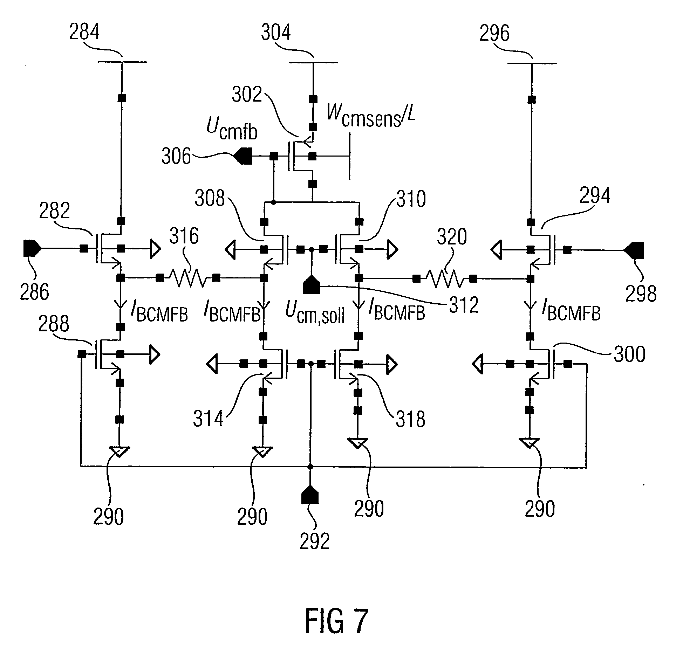

Der Transkonduktor 200 weist einen im wesentlichen symmetrischen Aufbau aus zwei im wesentlichen symmetrischen Zweigen 202, 204 auf. Der erste Zweig 202 umfaßt 4 Feldeffekt Transistoren 210, 220, 230, 240, deren Kanäle bzw. Source-Drain-Strecken zwischen einen Versorgungsspannungsanschluß 350 und einen Masseanschluß 253 geschaltet sind. Die Source des ersten Feldeffekttransistors 210 ist mit dem Versorgungsspannungsanschluß 250 verbunden, die Drain des ersten Feldeffekttransistors 310 ist mit der Source des zweiten Feldeffekttransistors 320 verbunden. Die Drain des zweiten Feldeffekttransistors 220 ist mit der Drain des dritten Feldeffekttransistors 230 verbunden, die Source des dritten Feldeffekttransistors 230 ist mit der Drain des vierten Feldeffekttransistors 240 verbunden, und die Source des vierten Feldeffekttransistors 240 ist mit dem Masseanschluß 252 verbunden. Die Kaskodenschaltung aus dem ersten Feldeffekttransistor 210 und dem zweiten Feldeffekttransistor 220 dient der Erzeugung eines besonders hohen Ausgangswiderstandes des Transkonduktors 200, wobei von einer weiter unten mit Bezug auf Fig. 7 beschriebenen Gleichtaktregelung über einen ersten Eingang 262 eine Spannung $U_{cmfb}$ an das Gate des ersten Feldeffekttransistors 210 angelegt wird. Ein zweiter Eingang 264 entspricht einem der Eingänge 172a, 172b, 182a, 182b, 192a, 192b in den Transkonduktoren 170, 180 bzw. 190 aus Fig. 5 und ist mit dem Gate des dritten Feldeffekttransistors 230 verbunden. Über den zweiten Eingang 264 wird der Bias-Strom $I_{BIAS}$ gesteuert, welcher der Drain-Strom des dritten Feldeffekttransistors 30 ist. Ein dritter Eingang 266 ist mit dem Gate des vierten Feldeffekttransistors 240 verbunden und bildet einen Hilfseingang, auf dessen Funktion im folgenden nicht näher eingegangen wird. Die Drain des zweiten Feldeffekttransistors 220 und die Drain des dritten Feldeffekttransistors 230 sind mit einem Ausgang 268 verbunden, der einem der Ausgänge 174a, 174b 184a, 184b, 194a, 194b der Transkonduktoren 170, 180 bzw. 190 aus Fig. 5 entspricht.

Der zweite Zweig 204 des Transkonduktors 200 ist symmetrisch zu dem ersten Zweig 202 aufgebaut. Den Bauelementen des zweiten Zweigs 204 wurden die gleichen Bezugszeichen wie den entsprechenden Bauelementen des ersten Zweigs 202, jedoch ergänzt um einen Apostroph ('), gegeben. Die Source des dritten Feldeffekttransistors 230 des ersten Zweigs 202 und die Drain des vierten Feldeffekttransistors 240 des ersten Zweigs 202 einerseits und die Source des dritten Feldeffekttransistors 230' des zweiten Zweigs 204 und die Drain des vierten Feldeffekttransistors 240' des zweiten Zweigs 104 andererseits sind über einen Widerstand $R_T$ miteinander verbunden.

Zur Erzielung eines hohen Ausgangswiderstandes $R_{out}$ des Transkonduktors 200 wird als Last für den dritten Feldeffekttransistor 230 die Kaskode $M_c/M_{cmfb}$ aus dem ersten Feldeffekttransistor 210 und dem zweiten Feldeffekttransistor 220 verwendet (Der Index "cmfb" steht für "common mode feedback" = Gleichtaktrückkopplung; der Parameter $L$ steht für die Gatelänge des Feldeffekttransistors). Als weitere Maßnahme für einen hohen Ausgangswiderstand $R_{out}$ des Transkonduktors wird eine Ausgangsgleichtaktregelung gewählt, die den Ausgang 268, 268' nicht resistiv belastet.

Fig. 7 ist ein schematisches Schaltungsdiagramm einer Ausgangsgleichtaktschaltung für den Transkonduktor aus Fig. 6. Die Ausgangsgleichtaktschaltung umfaßt einen ersten Feldeffekttransistor 282, dessen Drain mit einem ersten Versorgungsspannungsanschluß 284 verbunden ist, dessen Gate mit einem ersten Eingang 286 verbunden ist, und dessen Source mit der Drain eines zweiten Feldeffekttransistors 288 verbunden ist. Die Source des zweiten Feldeffekttransistors 288 ist mit Masse 290 verbunden und das Gate des zweiten Feldeffekttransistors 288 ist mit einem zweiten Eingang 292 verbunden. Die Drain eines dritten Feldeffekttransistors 294 ist mit einem zweiten Versorgungsspannungsanschluß 296 verbunden, das Gate des dritten Feldeffekttransistors 294 ist mit einem dritten Eingang 298 verbunden, und die Source des dritten Feldeffekttransistors 294 ist mit der Drain eines vierten Feldeffekttransistors 300 verbunden. Die Source des dritten Feldeffekttransistors 300 ist mit Masse 290 verbunden, und das Gate des dritten Feldeffekttransistors 300 ist ebenso wie das Gate des zweiten Feldeffekttransistors 288 mit dem zweiten Eingang 292 verbunden. Die Source eines fünften Feldeffekttransistors 312 ist mit einem dritten Versorgungsspannungsanschluß 304 verbunden, das Gate und die Drain des fünften Feldeffekttransistors 302 sind mit einander und mit einem Ausgang 306, der Drain eines sechsten Feldeffekttransistors 308 und der Drain eines siebten Feldeffekttransistors 310 verbunden. Das Gate des sechsten Feldeffekttransistors 308 und das Gate des siebten Feldeffekttransistors 310 sind miteinander und mit einem vierten Eingang 312 verbunden. Die Source des sechsten Feldeffekttransistors 308 ist mit der Drain eines achten Feldeffekttransistors 314 und über einen Widerstand 316 mit der Source des ersten Feldeffekttransistors 282 und der Drain des zweiten Feldeffekttransistors 288 verbunden. Die Source des siebten Feldeffekttransistors 310 ist mit der Drain eines neunten Feldeffekttransistors 318 und über einen Widerstand 320 mit der Source des dritten Feldeffekttransistors 294 und der Drain des vierten Feldeffekttransistors 300 verbunden. Das Gate des achten Feldeffekttransistors 314 und das Gate des neunten Feldeffekttransistors 318 sind wie das Gate des zweiten Feldeffettransistors 288 und das Gate des vierten Feldeffekttransistors 300 mit dem zweiten Eingang 292 verbunden. Die Source des achten Feldeffekttransistors 314 und die Source des neunten Feldeffekttransistors 318 sind mit Masse verbunden. Abgesehen von dem fünften Feldeffekttransistor 302 sind alle Feldeffekttransistoren 282, 288, 294, 300, 308, 310, 314, 318 in Substratbereichen bzw. Wannen gebildet, die mit Masse 290 verbunden sind. Der fünfte Feldeffekttransistor 302 ist einem Substratbereich bzw. in einer Wanne gebildet, die mit einem vierten Versorgungsspannungsanschluß 322 verbunden ist.

An dem vierten Eingang 312 liegt eine Spannung $U_{cm,soll}$ an. Die Drain-Ströme des zweiten Feldeffekttransistors 288, des vierten Feldeffettransistors 300, des achten Feldeffekttransistors 314 und des neunten Feldeffekttransistors 318 betragen jeweils $I_{BCMFB}$. Am Ausgang 306 erzeugt die Ausgangsgleichtaktregelung eine Spannung $U_{cmfb}$, die an die ersten Eingänge 262, 262' der beiden Zweige 202, 204 des Transkonduktors aus Abbildung 6 angelegt wird.

Für den Ausgangsgleichtakt $U_{cmout}(s)$ findet man

$$U_{cmout}(s) = \frac{\Delta I(s) - I_{BIAS} + \dfrac{U_{dd}}{Z_{Udd}(s)} + 2\dfrac{W_{cmfb}}{W_{cmsens}}I_{Bcmfb} - 2G_{mcm}\dfrac{W_{cmfb}}{W_{cmsens}}U_{cm,soll}}{\dfrac{Z_{Udd}(s) + Z_{gnd}(s)}{Z_{Udd}(s)Z_{gnd}(s)} + 2G_{mcm}\dfrac{W_{cmfb}}{W_{cmsens}}} \ .$$

Dabei sind $\Delta I(s)$ eine durch die Abweichung des Eingangsgleichtaktes vom Sollwert hervorgerufene Störung, $U_{dd}$ die Versorgungsspannung, $Z_{Udd}(s)$ die Impedanz zwischen einem der beiden Ausgänge und dem Versorgungsspannungsknoten, $Z_{gnd}(s)$ die Impedanz zwischen dem Ausgang 306 und der Masse 219 und $G_{mcm}(s)$ die Transkonduktanz einer einzelnen Differenzstufe in der Ausgangsgleichtaktregelung.

Je größer das Verhältnis $G_m W_{cmfb}/W_{cmsens}$ ist, desto besser kann der Ausgangsgleichtakt ausgeregelt werden. Die Spannung am Ausgang des Transkonduktors 200 ist jedoch dadurch begrenzt, daß nur für

$$u_{out} << \frac{4I_{Bcmfb}}{G_{mcm}}$$

ein linearer Zusammenhang zwischen $I_{cmsens}$ und dem Ausgangsgleichtakt herrscht. Bei größeren Spannungen versagt die Ausgangsgleichtaktregelung.

Da der Transkonduktor aus Fig. 6 und die Ausgangsgleichtaktregelung aus Fig. 7 so eingestellt werden müssen, daß

$$I_{Bcmfb} \approx \frac{W_{cmsens}}{2W_{cmfb}}\left(I_{BIAS} - \frac{U_{dd}}{Z_{Udd}(s)}\right)$$

gilt, ist

$$G_m \frac{W_{cmfb}}{W_{cmsens}} << \frac{I_{BIAS} - \dfrac{U_{dd}}{Z_{Udd}(s)}}{u_{out}}$$

Deshalb wird die Ausgangsgleichtaktregelung um so schwächer je größer die maximale Ausgangsamplitude ist.

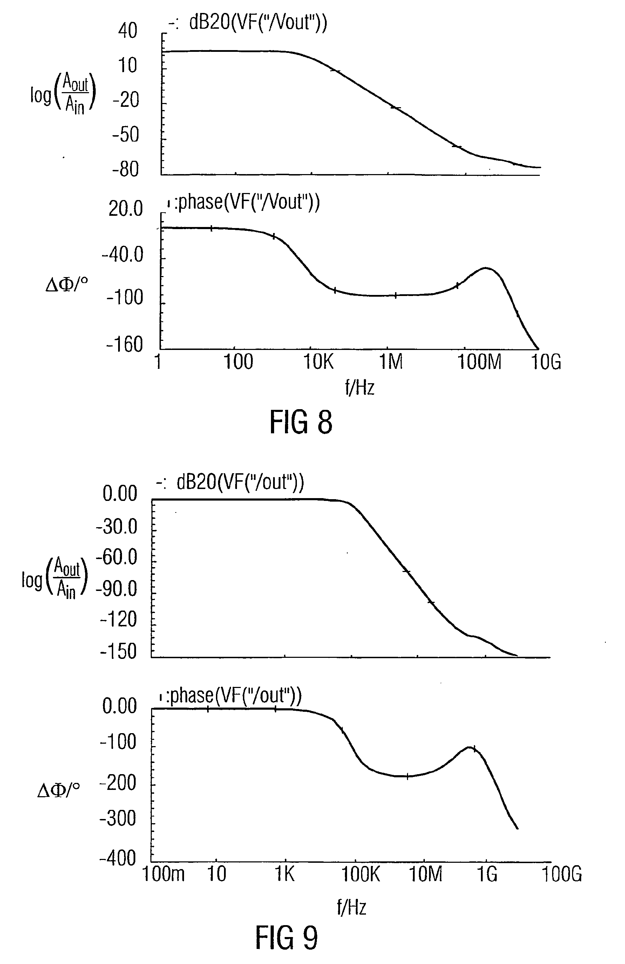

Fig. 8 zeigt ein Bodediagramm einer simulierten Übertragungsfunktion eines Transkonduktors, wie er in Fig. 6 dargestellt ist. Die Transkonduktanz $G_m$ des Transkonduktors beträgt $G_m$=7,5 μS. Ferner wurde bei der Simulation von einer den Ausgängen 268, 268' des Transkonduktors 200 nachgeschalteten Lastkapazität von C=12,5 pF ausgegangen. Der Abszisse ist in logarithmischer Teilung die Frequenz $f$ eines am Eingang 262, 262' des Transkonduktors 300 anliegenden harmonischen Signals zugeordnet. Den Ordinaten sind die "Dämpfung" des Transkonduktors 200 bzw. das logarithmische Verhältnis $\log(A_{out}/A_{in})$ der Amplitude $A_{out}$ des am Ausgang 268, 268' ausgegebenen Ausgangssignals und des am Eingang 262, 262' empfangenden harmonischen Eingangssignals $A_{in}$ (oben) und die Phase $\phi$ (unten) zugeordnet.

Die Frequenz des niederfrequentesten Pols der Übertragungsfunktion liegt bei $f$ = 6kHz. Eine Nullstelle und weitere Pole liegen bei Frequenzen in der Größenordnung einiger hundert MHz und damit weit außerhalb der angestrebten Bandbreite des mit dem Transkonduktor zu bildenden Biquad-Filters. Die Stromaufnahme des Transkonduktors 200 aus Fig. 6 beträgt ohne die Gleichtaktregelung aus Fig. 7 30 $\mu$A.

Fig. 9 ist ein schematisches Diagramm, daß die simulierte Übertragungsfunktion eines Biquad-Filters mit Transkonduktoren, wie sie in Fig. 6 dargestellt sind, in einem BodeDiagramm zeigt. Der Abszisse ist wiederum die Frequenz $f$ eines am Eingang des Biquad-Filters anliegenden harmonischen Eingangssignals zugeordnet. Der Ordinate ist die Dämpfung des Biquad-Filters (log($A_{out}/A_{in}$), oben) bzw. die Phasendifferenz $\Delta\phi$ zwischen dem am Eingang des Biquad-Filters anliegenden harmonischen Eingangssignals und dem am Ausgang des Biquad-Filters anliegenden Ausgangssignals zugeordnet. Die Gleichstromverstärkung des Biquad-Filters beträgt erwartungsgemäß nur minus 0,1 dB. Im Bereich von $f \approx 70$ kHz liegt der dem Polstellenpaar der Übertragungsfunktion des Biquad-Filters zugeordnete Phasensprung, die dem sich die Phasendifferenz um $\Delta\phi=\pi=180°$ ändert. Bei hohen Frequenzen $f >> 10$ MHz nehmen Betrag und Phase der Übertragungsfunktion große Fehler an, die den zusätzlichen Polen und Nullstellen zuzuschreiben sind.

Die obigen Ausführungen zeigen, daß unter Verwendung von Biquad-Filtern in einem Schleifenfilter einer Phasenregelschleife die Einschwingzeit T eines $\Sigma\Delta$-Fractional-N-Frequenzgenerator wesentlich verkürzt werden kann. Integratoren und Biquad-Filter in der Current-Mode-Technik zeichnen sich durch einen geringen Leistungsbedarf aus, wodurch auch der Leistungsbedarf des Schleifenfilters vergleichsweise sehr klein ist. Der beschriebene Transkonduktor basiert auf einem degenerierten Differenzverstärker. Dies ermöglicht eine sehr kleine Transkonduktanz des Transkonduktors.

Die oben beschriebene Ausgangsgleichtaktregelung mißt den Ausgangsgleichtakt nicht mit Hilfe eines resistiven Spannungsteiles, um eine Belastung des Ausgangs des Transkonduktors zu vermeiden und einen hohen Ausgangswiderstand desselben zu ermöglichen. Statt dessen wird der Ausgangsgleichtakt mit Hilfe zweier Differenzverstärker gemessen. Die erzielte Ausgangsgleichtaktregelung weist eine große Linearität auf.

In Fig. 9 ist zu erkennen, daß unerwünschte Nullstellen und Pole der Übertragungsfunktion des erfindungsgemäßen Biquad-Filters erst bei Frequenzen oberhalb von ca. 100 MHz auftreten. Dies zeigt die vielseitige Verwendbarkeit der beschriebenen Current-Mode-Biquad-Filter.

**Patentansprüche**

1. Frequenzgenerator mit:

   einer Phasenregelschleife (10),(20), (30), (40) mit einem Schleifenfilter (20),

   wobei das Schleifenfilter derart ausgebildet ist, daß eine Übertragungsfunktion des Schleifenfilters (20) ein Paar konjugiert komplexer Pole aufweist,
   **dadurch gekennzeichnet**
   **dass** das Schleifenfilter (20) ein aktives Biquäd-Filter (120) umfaßt, und
   **dass** die Übertragungsfunktion $H_{PLL}(s)$ der Phasenregelschleife als Quotient $H_{PLL}(s) = P_{PLL}(s)/Q_{PLL}(s)$ aus einem Zählerpolynom $P_{PLL}(s)$ und einem Nennerpolynom $Q_{PLL}(s)=q_{N-1,PLL}s^{N-1} + q_{N-2,PLL}s^{N-2} +...+ q_{0,PLL}s^0$ darstellbar ist, bei dem die Übertragungsfunktion $Z_{LF}(s)$ des Schleifenfilters als Quotient $Z_{LF}(s) = P_{LF}(s)/Q_{LF}(s)$ aus einem Zählerpolynom $P_{LF}(s) = p_{1,LF}s + p_{0,LF}$ und einem Nennerpolynom $Q_{LF}(s) = q_{N-1,LF}s^{N-1} + q_{N-2,LF}s^{N-2} +...+ q_{0,LF}s^0 = (s-s_{\infty PLL,1})\cdot(s-s_{\infty PLL,2})\cdot...\cdot(s-s_{\infty PLL,N})$ mit den Polen $s_{\infty PLL,n}$ darstellbar ist, bei dem die Pole $s_{\infty PLL,n}$ so gewählt sind, daß das Phasenrauschen der Phasenregelschleife einen vorbestimmten Wert aufweist und die Einschwingzeit der Phasenregelschleife minimal ist, und bei dem das Biquad-Filter Transkonduktoren mit der Transkonduktanz $G_m$, Kondensatoren mit den Kapazitäten $C_3$, $C_4$ und ein Widerstandsbauelement mit dem Widerstand $R_3$ umfaßt und die Verstärkung K und die Güte Q aufweist, wobei die Koeffizienten $q_{n,PLL}$, $p_{n,LF}$, $q_{n,LF}$, die Transkonduktanz $G_m$, die Kapazitäten $C_3$, $C_3$ und der Widerstand $R_3$ folgende Gleichungen erfüllen:

$$q_{n,LF} = q_{n+1,PLL} \, ,$$

$$q_{1,LF} = \frac{1}{C_3 R_3} + \frac{1}{R_{out} C_3} + \frac{1}{R_{out} C_4} \, ,$$

$$q_{0,LF} = \frac{G_m{}^2}{C_3 C_4} + \frac{1}{C_3{}^2 R_{out} C_4} + \frac{1}{R_{out}{}^2 C_3 C_4} \, ,$$

$$K = \omega_0 = \frac{G_m}{\sqrt{C_3 C_4}}$$

und

$$Q = R_3 C_3 \omega_0 \, .$$

2. Frequenzgenerator nach Anspruch 1, bei dem die Phasenregelschleife (10, 20, 30, 40) folgende Merkmale aufweist:

einen Phasen/Frequenz-Detektor (10) mit einem Differenzsignaleingang (12) zum Empfangen eines Referenzsignals mit einer Referenzfrequenz, einem Vergleichssignaleingang (14) zum Empfangen eines Vergleichssignals mit einer Vergleichsfrequenz und einem Steuerausgang (16) zum Ausgeben eines Oszillatorsteuersignals, das von der Differenz zwischen der Vergleichsfrequenz und der Referenzfrequenz oder von der Differenz der Phasen des Vergleichsignals und des Differenzsignals abhängt;
das Schleifenfilter (20) mit einem Eingang (22) zum Empfangen des Oszillatorsteuersignals und einem Ausgang (24) zum Ausgeben eines gefilterten Oszillatorsteuersignals;
einen Oszillator (30) mit einem Eingang (32) zum Empfangen des gefilterten Oszillatorsteuersignals und einem Ausgang (34) zum Ausgeben eines oszillierenden Ausgangssignals mit einer Ausgangsfrequenz, wobei der Oszillator (30) ausgebildet ist, um die Ausgangsfrequenz abhängig von dem gefilterten Oszillatorsteuersignal zu steuern;
einen Frequenzteiler (40) mit einem Eingang (42) zum Empfangen des oszillierenden Ausgangssignals und einem Ausgang (44) zum Ausgeben des Vergleichssignals, wobei der Frequenzteiler (40) so ausgebildet ist, das die Vergleichsfrequenz des ausgegebenen Vergleichssignals sich um einen Frequenzfaktor von der Ausgangsfrequenz des am Eingang (42) empfangenden Ausgangssignals unterscheidet; und
einen Ausgang (60) im Ausgeben des oszillierenden Ausgangsignals.

3. Frequenzgenerator nach Anspruch 2, bei dem der Frequenzteiler (40) ferner einen Eingang (46) zum Empfangen eines Frequenzfaktorsteuersignals aufweist und so ausgebildet ist, daß der Frequenzfaktor durch das Frequenzfaktorsteuersignal steuerbar ist.

4. Frequenzgenerator nach Anspruch 3, ferner mit:

einem Modulator (50) mit einem Eingang (52) zum Empfangen eines Digitalsignals, das einen erwünschten Frequenzfaktor darstellt, und einem Ausgang zum Ausgeben des Frequenzfaktorsteuersignals, wobei der Modulator (50) ausgebildet ist, um den Frequenzfaktor des Frequenzteilers (40) so zwischen verschiedenen ganzzahligen Bruchteilen von Eins hin- und her zu schalten, daß ein zeitlicher Mittelwert des Frequenzfaktors gleich dem erwünschten Frequenzfaktor ist, wenn der erwünschte Frequenzfaktor kein ganzzahliger Bruchteil von Eins ist.

**EP 1 606 882 B1**

**Claims**

1.  Frequency generator, comprising:

    a phase locked loop (10), (20), (30), (40) with a loop filter (20),

    wherein the loop filter is formed such that a transfer function of the loop filter (20) has a pair of complex conjugated poles,
    **characterized in that**
    the loop filter (20) includes an active biquad filter (120), and
    the transfer function $Hp_{LL}(s)$ of the phase locked loop can be represented as quotient $H_{PLL}(s) = P_{PLL}(s)/Q_{PLL}(s)$ of a numerator polynomial $P_{PLL}(s)$ and a denominator polynomial $Q_{PLL}(s) = q_{N-1,PLL}s^{N-1} + q_{N-2,PLL}s^{N-2} + ... + q_{0,PLL}s^0$, wherein the transfer function $Z_{LF}(s)$ of the loop filter can be represented as quotient $Z_{LF}(s) = P_{LF}(s)/Q_{LF}(s)$ of a numerator polynomial $P_{LF}(s) = p_{1,LF}s + p_{0,LF}$ and a denominator polynomial $Q_{LF}(s) = q_{N-1,LF}s^{N-1} + q_{N-2,LF}s^{N-2} + ... + q_{0,LF}s^0 = (s-s_{\infty PLL,1}) \cdot (s-s_{\infty PLL,2}) \cdot ... \cdot (s-s_{\infty PLL,N})$ with the poles $s_{\infty PLL,n}$, wherein the poles $s_{\infty PLL,n}$ are chosen so that the phase noise of the phase locked loop has a predetermined value and the settling time of the phase locked loop is minimal, and wherein the biquad filter includes transconductors with the transconductance $G_m$, capacitors with the capacitances $C_3$, $C_4$, and a resistor device with the resistance $R_3$ and has the amplification K and the quality Q, wherein the coefficients $q_{n,PLL}$, $p_{n,LF}$, $q_{n,LF}$, the transconductance $G_m$, the capacitances $C_3$, $C_4$ and the resistance $R_3$ satisfy the following equations:

    $$q_{n,LF} = q_{n+1,PLL} \; ,$$

    $$q_{1,LF} = \frac{1}{C_3 R_3} + \frac{1}{R_{out} C_3} + \frac{1}{R_{out} C_4} \; ,$$

    $$q_{0,LF} = \frac{G_m^{\;2}}{C_3 C_4} + \frac{1}{C_3^{\;2} R_{out} C_4} + \frac{1}{R_{out}^{\;2} C_3 C_4} \; ,$$

    $$K = \omega_0 = \frac{G_m}{\sqrt{C_3 C_4}} \; ,$$

    and

    $$Q = R_3 C_3 \omega_0 \; .$$

2.  Frequency generator of claim 1, wherein the phase locked loop (10, 20, 30, 40) comprises:

    a phase/frequency detector (10) with a differential signal input (12) for receiving a reference signal with a reference frequency, a comparison signal input (14) for receiving a comparison signal with a comparison frequency, and a control output (16) for outputting an oscillator control signal, which depends on the difference between the comparison frequency and the reference frequency or on the difference of the phases of the comparison signal and of the difference signal;
    the loop filter (20) with an input (22) for receiving the oscillator control signal and an output (24) for outputting a filtered oscillator control signal;
    an oscillator (30) with an input (32) for receiving the filtered oscillator control signal and an output (34) for outputting an oscillating output signal with an output frequency, wherein the oscillator (30) is formed to control the output frequency depending on the filtered oscillator control signal;

16

a frequency divider (40) with an input (42) for receiving the oscillating output signal and an output (44) for outputting the comparison signal, wherein the frequency divider (40) is formed so that the comparison frequency of the output comparison signal differs from the output frequency of the output signal received at the input (42) by a frequency factor; and

an output (60) for outputting the oscillating output signal.

3. Frequency generator of claim 2, wherein the frequency divider (40) further comprises an input (46) for receiving a frequency factor control signal and is formed so that the frequency factor is controllable by the frequency factor control signal.

4. Frequency generator of claim 3, further comprising:

a modulator (50) with an input (52) for receiving a digital signal representing a desired frequency factor and an output for outputting the frequency factor control signal, wherein the modulator (50) is formed to switch the frequency factor of the frequency divider (40) between different integer fractions of one, so that a temporal average of the frequency factor is equal to the desired frequency factor, when the desired frequency factor is not an integer fraction of one.

## Revendications

1. Générateur de fréquence, avec:

une boucle de réglage de phase (10), (20), (30), (40) avec un filtre de boucle (20),
le filtre de boucle étant réalisé de sorte qu'une fonction de transmission du filtre de boucle (20) présente une paire de pôles complexes conjugués,

**caractérisé par le fait**
**que** le filtre de boucle (20) comporte un filtre biquad actif (120), et
**que** la fonction de transmission $H_{PLL}(s)$ de la boucle de réglage de phase peut être représentée comme quotient $H_{PLL}(s) = P_{PLL}(s)/Q_{PLL}(s)$ d'un polynôme numérateur $H_{PLL}(s)$ et d'un polynôme dénominateur $Q_{PLL}(s) = q_{N-1,PLL}s^{N-1} + q_{N-2,PLL}s^{N-2} + ... + q_{0,PLL}s^0$, dans lequel la fonction de transmission $Z_{LF}(s)$ du filtre de boucle peut être représentée comme quotient $Z_{LF}(s) = P_{LF}(s)/Q_{LF}(s)$ d'un polynôme numérateur $P_{LF}(s) = P_{1,LF}s + P_{0,LF}$ et d'un polynôme dénominateur $Q_{LF}(s) = q_{N-1,LF}s^{N-1} + q_{N-2,LF}s^{N-2} + ... + q_{0,LF}s^0 = (s-s_{\infty PLL,1})\cdot(s-s_{\infty PLL,2})\cdot ... \cdot(s-s_{\infty PLL,N})$ avec les pôles $s_{\infty PLL,n}$, dans lequel les pôles $s_{\infty PLL,n}$ sont choisis de sorte que le bruit de phase de la boucle de réglage de phase présente une valeur prédéterminée et que le temps de montée de la boucle de réglage de phase soit minimale, et dans lequel le filtre biquad comporte des transconducteurs à la transconductance $G_m$, des condensateurs aux capacités $C_3$, $C_4$ et un composant de résistance à la résistance $R_3$ et présente l'amplification K et la qualité Q, les coefficients $q_{n,PLL}$, $p_{n,LF}$, $q_{n,LF}$, la transconductance $G_m$, les capacités $C_3$, $C_3$ et la résistance $R_3$ remplissent les équations suivantes:

$$q_{n,PLL} = q_{n+1,PLL},$$

$$q_{1,LF} = \frac{1}{C_3 R_3} + \frac{1}{R_{out} C_3} + \frac{1}{R_{out} C_4},$$

$$q_{0,LF} = \frac{G_m^2}{C_3 C_4} + \frac{1}{C_3^2 R_{out} C_4} + \frac{1}{R_{out}^2 C_3 C_4},$$

$$K = \omega_0 = \frac{G_m}{\sqrt{C_3 C_4}}$$

et

$$Q = R_3 C_3 \omega_0.$$

**2.** Générateur de fréquence selon la revendication 1, dans lequel la boucle de réglage de phase (10, 20, 30, 40) présente les caractéristiques suivantes:

un détecteur de phase/fréquence (10) avec une entrée de signal de différence (12) destiné à recevoir un signal de référence avec une fréquence de référence, une entrée de signal de comparaison (14) destinée à recevoir un signal de comparaison avec une fréquence de comparaison et une sortie de commande (16) destinée à sortir un signal de commande d'oscillateur qui est fonction de la différence entre la fréquence de comparaison et la fréquence de référence ou de la différence entre les phases du signal de comparaison et du signal de différence;
le filtre de boucle (20) avec une entrée (22) destinée à recevoir le signal de commande d'oscillateur et une sortie (24) destinée à sortir un signal de commande d'oscillateur filtré;
un oscillateur (30) avec une entrée (32) destinée à recevoir le signal de commande d'oscillateur filtré et une sortie (34) destinée à sortir un signal de sortie oscillant avec une fréquence de sortie, l'oscillateur (30) étant réalisé de manière à régler la fréquence de sortie en fonction du signal de commande d'oscillateur filtré;
un diviseur de fréquence (40) avec une entrée (42) destinée à recevoir le signal de sortie oscillant et une sortie (44) destinée à sortir le signal de comparaison, le diviseur de fréquence (40) étant réalisé de sorte que la fréquence de comparaison du signal de comparaison sorti diffère d'un facteur de fréquence de la fréquence de sortie du signal de sortie reçu à l'entrée (42); et
une sortie (60) destinée à sortir le signal de sortie oscillant.

**3.** Générateur de fréquence selon la revendication 2, dans lequel le diviseur de fréquence (40) présente par ailleurs une entrée (46) destinée à recevoir un signal de réglage de facteur de fréquence et est réalisé de sorte que le facteur de fréquence puisse être réglé par le signal de réglage de facteur de fréquence.

**4.** Générateur de fréquence selon la revendication 3, par ailleurs avec:

un modulateur (50) avec une entrée (52) destinée à recevoir un signal numérique représentant un facteur de fréquence désiré, et une sortie destinée à sortie le signal de réglage de facteur de fréquence, le modulateur (50) étant réalisé de manière à commuter le facteur de fréquence du diviseur de fréquence (40) en va-et-vient entre différentes fractions de nombre entier de un, de sorte qu'une valeur moyenne dans le temps du facteur de fréquence soit égal au facteur de fréquence souhaité lorsque le facteur de fréquence souhaité n'est pas une fraction de nombre entier de un.

FIG 1

20

FIG 2

FIG 3

150

152

$\underline{I}_{in}$

160

162

154

$\underline{I}_{out}$

158

$G_m$

$C$

156

## FIG 4

120

124A

172A    174A

182A    184A

122A

192A

194A

$G_m$    $C_3$    $R_3$    $G_m$    $C_4$    $G_m$

194B

122B

172B    174B

182B    184B

192B    190

170

180

124B

## FIG 5

200

202

204

250

$M_{cmfb1}$  $W_{cmfb}/L$

$M_{cmfb2}$  $W_{cmfb}/L$  $U_{cmfb}$

$U_{cmfb}$

210

262

210'

262'

$M_{c1}$

$M_{c2}$

220

220'

268

268'

$I_{BIAS}$

$I_{BIAS}$

264

230

230'

264'

266

264

240

$R_T$

240'

266'

266

252

252'

FIG 6

FIG 7

**FIG 8**

**FIG 9**

**FIG 10**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5977838 A
- US 6008703 A

- US 3740671 A

**In der Beschreibung aufgeführte Nicht-Patentliteratur**

- **D. DE MUER ; M. S. J. STEYAERT.** A CMOS Monolithic ΣΔ-Controlled Fractional-N Frequency Sythesizer for DCS-1800. *IEEE J. Solid-State Circuits,* 2002, vol. 37 (7), 835-44
- MAX260/MAX261/MAX262 Micropocessor Programmable Universal Active Filters. *MAXIM Integrated Products USA,* 2002
- **F. M. GARDNER.** Charge-Pump Phase-Lock Loops. *IEEE Trans. Commun.,* 1980, vol. COM-28, 1849-58

- **J.C. LAGARIAS et al.** Convergence Properties of The Nelder-Mead Simplex-Method in Low Dimension. *SIAM J. Optim,* 1998, vol. 9 (1), 112-47
- **VON N. CHRISTOFFERS et al.** Accurate CMOS Current-Mode-Filters for High Frequencies and Low Power Consumption'' von N. Christoffers quencies and Low Power Consumption. *Konferenzband der ANALOG'02,* 2002, 343-48